Europäisches Patentamt

European Patent Office

Office européen des brevets

(11) Numéro de publication: **0 083 529**
**A2**

## (12) DEMANDE DE BREVET EUROPEEN

(21) Numéro de dépôt: **82402359.2**

(22) Date de dépôt: **22.12.82**

(51) Int. Cl.³: **H 03 F 1/02**

(30) Priorité: **31.12.81 FR 8124623**

(43) Date de publication de la demande: **13.07.83**
**Bulletin 83/28**

(84) Etats contractants désignés: **DE GB NL**

(71) Demandeur: **Neubauer, Michel, 89 Voie de Compiègne,**
**F-91390 Morsang sûr Orge (FR)**

(72) Inventeur: **Neubauer, Michel, 89 Voie de Compiègne,**
**F-91390 Morsang sûr Orge (FR)**

(74) Mandataire: **Mongrédien, André et al, c/o**
**BREVATOME 25, rue de Ponthieu, F-75008 Paris (FR)**

(54) **Ensemble d'amplification pour tensions de fortes excursions et source de tension comprenant un tel ensemble d'amplifications.**

(57) L'invention concerne un ensemble d'amplification pour tensions de fortes excursions et une source de tension comprenant un tel ensemble d'amplification.

L'ensemble d'amplification comprend un circuit d'amplification (2) comportant un amplificateur opérationnel (4, R, R₃) relié électriquement à un transistor de type NPN (8) et à un transistor de type PNP (10) permettant de moduler la tension d'alimentation de l'amplificateur opérationnel (4, R, R₃) par le signal de sortie fourni par ledit amplificateur, chaque transistor étant relié d'une part, à une source d'alimentation électrique dont la tension est n fois la tension d'alimentation de l'amplificateur opérationnel, et d'autre part, à un point diviseur par 2 (6), branché entre la source d'alimentation dudit transistor et la sortie (S) de l'amplificateur opérationnel.

0083529

La présente invention a pour objet un ensemble d'amplification pour tensions de fortes excursions et une source de tension comprenant un tel ensemble d'amplification. L'invention s'applique dans le domaine de l'amplification de signaux haute tension alternatifs ou continus et dans la réalisation de sources de hautes tensions alternatives ou continus.

Parmi les ensembles d'amplification et les sources de tensions actuellement connus, certains sont constitués d'une association de transistors de type NPN et de type PNP. Etant donné que les transistors de types PNP ne sont pas capables actuellement de supporter des tensions d'alimentation supérieures à 300 volts, l'utilisation de ces transistors limite la tension délivrée en sortie de ces ensembles d'amplification et de ces sources d'alimentation à 100 volts efficaces. En revanche, ces ensembles d'amplification et ces sources d'alimentation présentent l'avantage de fonctionner soit en continu, soit en alternatif.

D'autres ensembles d'amplification et sources de tension sont constitués d'un amplificateur qui est formé d'un amplificateur opérationnel suivi d'un amplificateur de puissance alimenté en basse tension dont la sortie est connectée sur un transformateur large bande. Etant donné la présence de ce transformateur, ces ensembles d'amplification et ces sources ne peuvent fonctionner qu'en alternatif mais délivrent en sortie des tensions élevées.

La présente invention a justement pour objet un ensemble d'amplification pour tensions de fortes excursions et une source de tension comprenant un tel ensemble d'amplification permettant de remédier à ces inconvénients.

En effet, cet ensemble d'amplification et cette source de tension permettent notamment la pro-

B 7381 C/CL

duction en sortie d'une tension élevée et peuvent fonctionner soit en continu, soit en alternatif.

De façon plus précise, l'invention a pour objet un ensemble d'amplification pour tension de fortes excursions, se caractérisant en ce qu'il comprend un circuit d'amplification comportant un amplificateur opérationnel relié électriquement à un premier et à un deuxième circuits permettant de moduler la tension d'alimentation de l'amplificateur opérationnel par le signal de sortie fourni par ledit amplificateur, chaque circuit de modulation étant relié d'une part, à une source d'alimentation électrique dont la tension est n fois la tension d'alimentation de l'amplificateur opérationnel, et d'autre part, à un pont diviseur par n, branché entre la source d'alimentation dudit circuit de modulation et la sortie de l'amplificateur opérationnel.

Selon un mode préféré de réalisation de l'ensemble d'amplification de l'invention, les ponts diviseurs sont des ponts diviseurs par deux.

Un ensemble d'amplification tel que défini ci-dessus permet d'augmenter et notamment de doubler la tension d'alimentation d'un amplificateur et donc de doubler la tension délivrée à la sortie de cet amplificateur.

Selon un autre mode préféré de l'ensemble d'amplification de l'invention, ce dernier est tel que :
- le premier circuit de modulation comprend un transistor de type NPN dont l'émetteur commande une entrée d'alimentation positive de l'amplificateur opérationnel et dont le collecteur est relié directement à la borne positive d'une première source d'alimentation électrique ;
- le deuxième circuit de modulation comprend un transistor de type PNP dont l'émetteur est relié direc-

B 7381 C/CL

tement à une entrée d'alimentation négative de l'amplificateur opérationnel et dont le collecteur est raccordé à la borne négative d'une deuxième source d'alimentation électrique ; et

- chaque pont diviseur comprend deux résistances $R_1$ et $R_2$ reliées en série dont le point commun est connecté directement à la base du transistor auquel le pont diviseur est relié.

Selon une variante de ce mode de réalisation, l'émetteur du transistor de type NPN est connecté directement à l'entrée d'alimentation positive de l'amplificateur opérationnel et le collecteur du transistor de type PNP est connecté directement à la borne négative de la deuxième source d'alimentation électrique.

Selon une autre variante de ce mode de réalisation, l'émetteur du transistor de type NPN est connecté directement à la base d'un deuxième transistor de type NPN, dont l'émetteur est connecté directement à l'entrée d'alimentation positive de l'amplificateur opérationnel et dont le collecteur est relié directement à la borne positive de la première source d'alimentation électrique, et le collecteur du transistor PNP est connecté directement à la base d'un troisième transistor de type NPN, dont le collecteur est connecté directement à l'entrée d'alimentation négative de l'amplificateur opérationnel et dont l'émetteur est relié directement à la borne négative de la deuxième source d'alimentation électrique.

Selon un autre mode préféré de réalisation de l'invention, le circuit d'amplification comprend au moins un amplificateur de type push-pull série, comportant ou non un montage de type Darlington, branché en parallèle sur l'amplificateur opérationnel. Ceci

B 7381 C/CL

permet la réalisation d'un ensemble d'amplification de forte puissance.

Selon un autre mode préféré de réalisation de l'invention, l'ensemble d'amplification comprend un autre circuit d'amplification, les deux circuits d'amplification étant connectés suivant une configuration en H. L'utilisation d'un ensemble d'amplification comportant deux circuits d'amplification connectés suivant une configuration en H permet de doubler la tension de sortie de cet ensemble.

Selon une variante de ce mode de réalisation, l'ensemble d'amplification comprend, de plus, un circuit d'isolement relié à une entrée de l'un des deux circuits d'amplification, la sortie de l'un des deux circuits correspondant à la sortie de l'ensemble d'amplification et la sortie de l'autre circuit étant reliée à la masse.

L'invention a aussi pour objet une source de tension comprenant un ensemble d'amplification tel que décrit précédemment et un générateur de fonction relié à une entrée de l'un des deux circuits d'amplification, la sortie de l'un des deux circuits correspondant à la sortie de la source et la sortie de l'autre circuit étant reliée à la masse.

De préférence, l'ensemble d'amplification et la source de tension seront réalisés sous la forme d'un circuit intégré.

D'autres caractéristiques et avantages de l'invention apparaîtront mieux dans la description qui suit, donnée à titre explicatif mais nullement limitatif, en référence aux figures annexées sur lesquelles :

- la figure 1 représente, schématiquement, un ensemble d'amplification selon l'invention, comprenant un seul circuit d'amplification selon une première variante ;

- la figure 2 illustre le principe sur lequel est basée l'augmentation de la tension d'alimentation de l'amplificateur opérationnel constituant le circuit d'amplification de la figure 1 ;

- la figure 3 représente, schématiquement, un ensemble d'amplification selon l'invention, comprenant un seul circuit d'amplification selon une deuxième variante ;

- la figure 4 représente, schématiquement, un ensemble d'amplification selon l'invention, comprenant deux circuits d'amplification tels que représentés sur la figure 1 connectés suivant une configuration en H, la sortie étant flottante ;

- la figure 5 représente une variante de l'ensemble d'amplification de la figure 4, la sortie s'effectuant par rapport à la masse ;

- la figure 6 représente, schématiquement, un ensemble d'amplification selon l'invention, comprenant le circuit d'amplification de la figure 1 auquel est associé un amplificateur de type push-pull série ; et,

- la figure 7 représente, schématiquement, un ensemble d'amplification selon l'invention, comprenant le circuit d'amplification de la figure 2 auquel est associé un amplificateur de type push-pull série comprenant un montage Darlington.

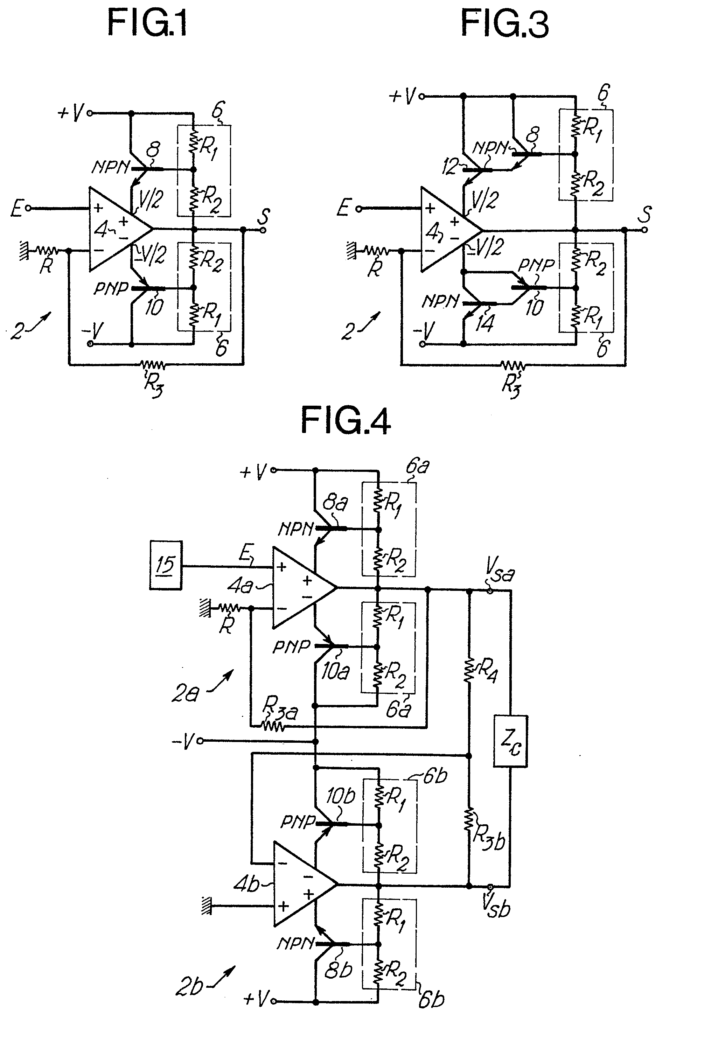

L'ensemble d'amplification, conformément à l'invention, comprend, comme représenté sur les figures 1, 3 à 7, un circuit d'amplification 2 comportant un amplificateur opérationnel formé d'un amplificateur 4 dont l'une des entrées est reliée à la masse, ici l'entrée négative, par l'intermédiaire d'une résistance R, et dont l'autre entrée, ici l'entrée positive, constitue l'entrée E du circuit d'amplification 2. Cette entrée peut être portée à une tension continue ou une tension alternative. Cet amplificateur opérationnel est de plus muni d'une résistance $R_3$ branchée entre l'entrée négative et la sortie S de l'amplificateur 4. La résistance R et la résistance $R_3$ définissent le gain de l'amplificateur opérationnel.

Cet amplificateur opérationnel 4, R, $R_3$ est relié électriquement à deux circuits de modulation, que l'on décrira ultérieurement, qui permettent de moduler la tension d'alimentation de l'amplificateur opérationnel par le signal fourni à la sortie S de l'amplificateur opérationnel, donc du circuit d'amplification 2. Chaque circuit de modulation est alimenté par une tension qui est n fois la tension d'alimentation normale de l'amplificateur opérationnel (tension maximale applicable à l'amplificateur opérationnel seul). De plus, chaque circuit de modulation est relié à un pont diviseur par n, portant la référence 6, branché entre la source d'alimentation électrique associée audit circuit de modulation et la sortie S de l'amplificateur opérationnel. Les ponts diviseurs sont de préférence des ponts diviseurs par deux.

La multiplication par n et notamment par deux de la tension d'alimentation du circuit d'amplification 2, et donc de la tension délivrée à la sortie de ce circuit, est possible du fait que le circuit d'amplification et notamment l'amplificateur opérationnel le constituant sont symétriques ; les signaux positifs sont amplifiés par une moitié du circuit d'amplification et les signaux négatifs par l'autre moitié du circuit d'amplification. De plus, ce circuit d'amplification 2 permet, comme illustré sur la figure 2, d'augmenter la tension positive d'alimentation de ce circuit et de diminuer la tension négative d'alimentation de celui-ci, lorsque le signal de sortie S est positif et inversement, lorsqu'il est négatif. Les droites A et B indiquent le niveau de la tension d'alimentation normale de l'amplificateur opérationnel avec un signal nul à l'entrée.

Dans la suite de la description, les ponts diviseurs 6 utilisés seront des ponts diviseurs par deux. Chaque pont diviseur 6 comporte deux résistances $R_1$ et $R_2$ reliées en série.

Sur la figure 1, on a représenté une première variante du circuit d'amplification 2 de l'ensemble d'amplification selon l'invention. Dans cette variante, l'un des circuits de modulation est constitué d'un transistor 8 de type NPN monté en collecteur commun ; l'émetteur est connecté directement à l'entrée d'alimentation positive de l'amplificateur opérationnel 4, $R$, $R_3$, et le collecteur est connecté directement à la borne positive d'une première source d'alimentation électrique délivrant une tension +V, la base de ce transistor 8 étant connectée directement au point commun des résistances $R_1$ et $R_2$, formant le pont diviseur 6 associé à ce transistor 8.

De même, l'autre circuit de modulation est constitué d'un transistor 10 de type PNP monté en collecteur commun ; l'émetteur est connecté directement à l'entrée d'alimentation négative de l'amplificateur opérationnel 4, $R$, $R_3$, et le collecteur est connecté directement à la borne négative d'une deuxième source d'alimentation électrique délivrant une tension -V, la base de ce transistor 10 étant connectée directement au point commun des résistances $R_1$ et $R_2$, formant le pont diviseur 6 associé à ce transistor 10.

Dans cette variante, afin d'obtenir rigoureusement des ponts diviseurs par deux, la valeur de la résistance $R_2$ des ponts diviseurs 6 devra être légèrement supérieure à celle de la résistance $R_1$, étant donné la présence d'un léger courant de base.

Ce circuit d'amplification, lorsque la tension d'alimentation des circuits de modulation et donc des transistors 8 et 10 est égale à $\pm$ 300 V, permet de

0083529

fournir en sortie une tension de 560 V crête à crête, soit une tension efficace de 200 V.

Le circuit d'amplification, tel que décrit ci-dessus, ne modifie en rien les autres caractéristiques électriques de l'amplificateur opérationnel 4, R, $R_3$. Cependant, il faudra à ces derniers, par rapport à l'utilisation d'un amplificateur opérationnel seul, un temps deux fois plus grand pour atteindre une tension double en sortie, ce qui est tout à fait normal.

Par ailleurs, l'utilisation dans le circuit d'amplification d'un amplificateur opérationnel permet l'emploi d'une source d'alimentation continue quelconque étant donné le taux de réjection élevé d'un tel amplificateur vis-à-vis de son alimentation ; on peut par exemple alimenter l'amplificateur opérationnel avec une tension alternative monophasée, redressée et filtrée, ou triphasée, seulement redressée en hexaphasé (sans filtrage, le taux d'ondulation étant de 4%).

Sur la figure 3, on a représenté une deuxième variante du circuit d'amplification 2 de l'ensemble d'amplification selon l'invention. Dans cette variante, le premier circuit de modulation comprend, comme précédemment, un transistor 8 de type NPN monté en collecteur commun ; l'émetteur commande l'entrée d'alimentation positive de l'amplificateur opérationnel 4, R, $R_3$ et le collecteur est connecté directement à la borne positive de la première source d'alimentation électrique délivrant la tension +V, la base de ce transistor 8 étant connectée directement au point commun des résistances $R_1$ et $R_2$, formant le pont diviseur 6 associé à ce transistor 8.

Dans cette variante, la commande, par l'émetteur de ce transistor 8, de l'entrée d'alimentation positive de l'amplificateur opérationnel se fait par l'intermédiaire d'un deuxième transistor 12 de type NPN monté en collecteur commun ; la base de ce transistor 12 est reliée directement à l'émetteur du

B 7381 C/CL

transistor 8 et l'émetteur de ce transistor 12 à l'entrée d'alimentation positive de l'amplificateur opérationnel 4, R, $R_3$. Le collecteur de ce transistor 12 est connecté directement à la borne positive de la première source d'alimentation électrique. Ce type de montage est appelé un montage Darlington.

De même, le deuxième circuit de modulation comprend, comme précédemment, un transistor 10 de type PNP dont l'émetteur est relié directement à l'entrée négative de l'amplificateur opérationnel 4, R, $R_3$ et dont le collecteur est raccordé à la borne négative de la deuxième source d'alimentation électrique délivrant la tension -V, la base de ce transistor 10 étant connectée directement au point commun des résistances $R_1$ et $R_2$, formant le pont diviseur 6 associé à ce transistor 10.

Dans cette variante, le raccordement du collecteur de ce transistor 10 à la deuxième source d'alimentation se fait par l'intermédiaire d'un troisième transistor 14 de type NPN, dont la base est reliée directement au collecteur du transistor 10 et dont l'émetteur est connecté directement à la borne négative de la deuxième source d'alimentation électrique. Le collecteur de ce transistor 14 est connecté directement à l'entrée d'alimentation négative de l'amplificateur opérationnel 4, R, $R_3$. Ce montage est généralement appelé un montage super-collecteur commun.

Dans cette variante, l'obtention des ponts diviseurs par deux se fait en utilisant une résistance $R_1$ et une résistance $R_2$ de même valeur.

L'utilisation de l'une ou l'autre variante du circuit d'amplification 2, dépend du type d'amplificateur opérationnel utilisé ainsi que du type d'application envisagé. La deuxième variante sera par exemple utilisée avec un amplificateur consommant plusieurs dizaines de milliampères. Des exemples d'amplificateurs opérationnels pouvant être utilisés dans le circuit d'amplification selon l'invention seront donnés ultérieurement.

Afin de doubler une nouvelle fois la tension de sortie de l'ensemble d'amplification de l'invention, on peut associer deux circuits d'amplification 2 de structure identique. Ces deux circuits d'amplification sont reliés entre eux de façon que la tension amplifiée soit disponible entre les sorties des deux circuits d'amplification, c'est-à-dire suivant une configuration en H. Un tel ensemble d'amplification est schématisé sur la figure 4.

Sur cette figure, chaque circuit d'amplification présente la structure illustrée sur la figure 1, c'est-à-dire conformément à la première variante de réalisation de ces circuits. Bien entendu, cette association de deux circuits d'amplification peut être envisagée, lorsque chacun des circuits présente la structure illustrée sur la figure 3, c'est-à-dire conformément à la deuxième variante de réalisation de ces circuits.

Les éléments constituant le premier circuit d'amplification 2a portent les références indicées $\underline{a}$ et les éléments constituant le deuxième circuit d'amplification 2b portent les références indicées $\underline{b}$. Entre les deux sorties $V_{sa}$ et $V_{sb}$ des deux circuits d'amplification 2a et 2b peut être branchée une impédance de charge $Z_c$.

Pour obtenir une tension double entre les deux sorties $V_{sa}$ et $V_{sb}$ des deux circuits d'amplification 2a et 2b par rapport à la tension obtenue en sortie lors de l'utilisation d'un seul circuit d'am-

B 7381 C/CL

plification, il faut que, les deux circuits étant branchés en parallèle sur les mêmes sources d'alimentation, les transistors 8a et 8b soient rendus conducteurs pour une alternance de la tension d'alimentation, les transistors 10a et 10b restant alors bloqués et que réciproquement, les transistors 10a et 10b soient rendus conducteurs pour l'autre alternance de cette tension, les transistors 8a et 8b restant alors bloqués.

Pour réaliser cette condition de phase, il faut réaliser à la sortie du circuit d'amplification 2a une inversion du signal dans le circuit d'amplification 2b avec un gain de 1. Pour réaliser le gain 1, il faut que la résistance $R_4$, branchée en série avec la résistance $R_{3b}$ du circuit d'amplification 2b, soit égale à la résistance $R_{3b}$.

Un tel ensemble d'amplification permet de fournir, lorsque la tension d'alimentation égale à ± 300 V, une tension de sortie de 1 120 V crête à crête soit, une tension efficace de 400 V.

Avec un ensemble d'amplification comportant deux circuits d'amplification connectés suivant une configuration en H, on peut facilement réaliser une source de haute tension alternative. Pour cela, il suffit de connecter à l'une des entrées de l'un des deux circuits d'amplification et par exemple à l'entrée E de l'ensemble d'amplification, un générateur de fonction 15, c'est-à-dire un générateur engendrant par exemple des tensions carrées, triangulaires ou sinusoïdales et même complexes de valeur moyenne nulle. Cependant, la charge en sortie est flottante, et de ce fait isolée de la masse.

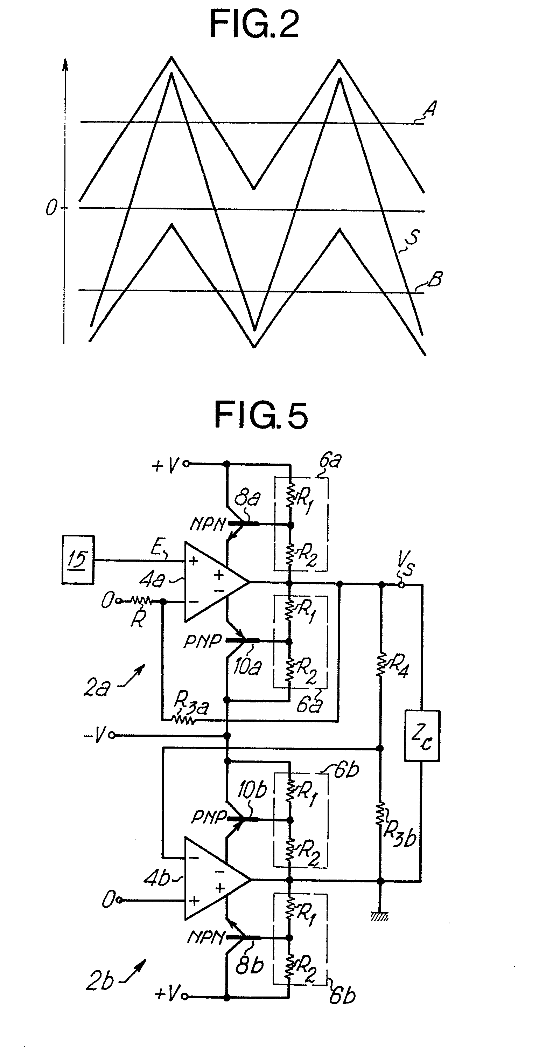

A l'inverse pour obtenir la tension de sortie par rapport à la masse comme cela est représenté sur la figure 5, la sortie de l'un des deux circuits

B 7381 C/CL

d'amplification, ici le circuit 2b, doit être reliée à la masse, tandis que la sortie de l'autre circuit d'amplification, ici le circuit 2a, constitue la sortie de l'ensemble d'amplification ou de la source de tension. Dans ce cas les entrées des circuits d'amplification sont isolées et il faudra utiliser un générateur de fonction dont la sortie est isolée de la masse.

Afin de réaliser un ensemble d'amplification et une source de tension d'emploi universel, l'isolation se fait en utilisant un circuit d'isolement connecté à l'une des entrées de l'un des deux circuits d'amplification et par exemple à l'entrée E de l'ensemble d'amplification. Dans le cas où l'ensemble d'amplification fonctionne uniquement en alternatif, le circuit d'isolement peut être un simple condensateur ou un transformateur d'isolement. Dans le cas où l'ensemble d'amplification fonctionne en continu ou en alternatif, le circuit d'isolement peut être un photocoupleur constitué entre autres d'une diode électroluminescente suivie d'un photo-transistor. Dans un tel circuit d'isolement on utilise le courant de la diode qui est proportionnel à l'éclairement pour obtenir une courbe de réponse linéaire. Dans le commerce ce circuit d'isolement existe sous la forme d'un amplificateur d'isolement tel que celui connu sous la marque BURR-BROWN 3650.

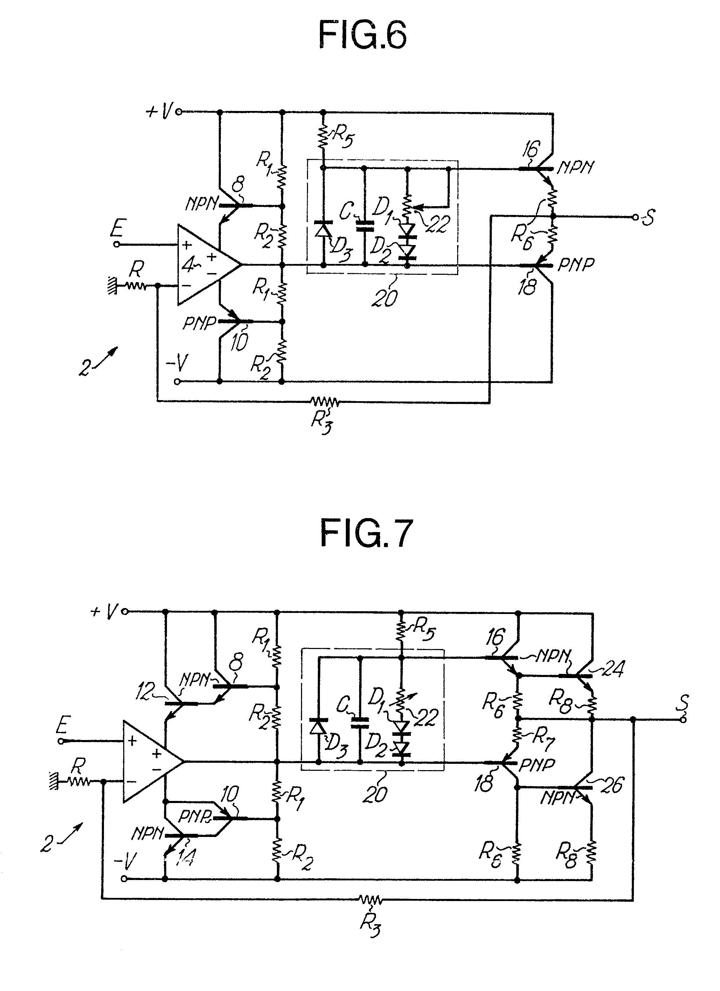

Par ailleurs, afin de réaliser des ensembles d'amplification ou des sources de tension, fonctionnant en continu ou en alternatif, de forte puissance, on peut adjoindre à chaque circuit d'amplification tel que décrit précédemment, un amplificateur de type push-pull classique. Dans le cas de circuits d'amplification réalisés selon la première variante (figures 1, 4, 5) on pourra associé à chacun de ces circuits un amplificateur de type push-pull série, branché en parallèle sur l'amplificateur opérationnel dudit circuit d'amplification, comme cela est schématisé sur la figure 6. Le nombre de transistors constituant cet amplificateur dépend bien entendu de la puissance qui l'on désire obtenir à la sortie.

L'amplificateur de type push-pull série comprend, de façon classique, deux résistances $R_6$ reliées en série, branchées entre l'émetteur d'un transistor 16 de type NPN et l'émetteur d'un transistor 18 de type PNP. Le collecteur du transistor 16 est relié directement à la borne positive de la première source d'alimentation électrique, et la base de ce transistor 16 à la sortie de l'amplificateur opérationnel, par l'intermédiaire d'un circuit 20, tandis que le collecteur du transistor 18 est relié directement à la borne négative de la deuxième source d'alimentation électrique et la base de ce transistor 18 directement à la sortie de l'amplificateur opérationnel. La sortie S de cet ensemble d'amplification est située entre les deux résistances $R_6$.

Le circuit 20 est un circuit qui permet de décaler la tension entre les bases des transistors 16 et 18 afin de les polariser en classes AB. Ce circuit comprend, par exemple, branchés entre la base des deux transistors, un potentiomètre 22, une diode $D_1$ et une diode $D_2$ branchés en série ; une diode $D_3$ branchée en opposition par rapport aux diodes $D_1$ et $D_2$ ; et, un condensateur C permettant le filtrage de la composante alternative du courant polarisant $D_1$ et $D_2$.

De plus, l'ensemble d'amplification représenté sur cette figure 6 comprend une résistance $R_5$ branchée entre la base et le collecteur du transistor 16 de façon à polariser les diodes $D_1$ et $D_2$.

De même, dans le cas de circuits d'amplification réalisé selon la deuxième variante (figure 3), on pourra associer, comme ci-dessus, à chacun de ces circuits un amplificateur de type push-pull série comportant un montage Darlington, comme cela est schéma-

B 7381 C/CL

tisé sur la figure 7. Comme précédemment, le nombre de transistors constituant cet amplificateur dépend bien entendu de la puissance que l'on désire obtenir à la sortie.

Cet amplificateur comprend deux résistances $R_6$ et $R_7$, un transistor de type NPN 16 et un transistor de type PNP 18 reliés entre eux comme pour l'amplificateur de type push-pull simple (figure 6), si ce n'est que le transistor 18 est relié à la borne négative de la deuxième source d'alimentation par l'intermédiaire d'une résistance $R_6$. De même, un circuit 20 est prévu pour décaler la tension entre les bases des transistors 16 et 18, ainsi qu'une résistance $R_5$.

Cet amplificateur comprend de plus, un transistor NPN 24 monté en collecteur commun, l'émetteur de ce transistor 24 étant relié au collecteur d'un autre transistor 26 de type NPN par l'intermédiaire d'une résistance $R_8$ et la base de ce transistor 24 à l'émetteur du transistor 16. Par ailleurs, l'émetteur du transistor 26 est relié à la borne négative de la deuxième source d'alimentation par l'intermédiaire d'une résistance $R_8$ et la base de ce transistor 24 au collecteur du transistor 18.

L'ensemble d'amplification et la source de tension, conformément à l'invention, peuvent être utilisés pour fournir et amplifier des signaux continus ou alternatifs. Cet ensemble d'amplification et cette source de tension peuvent être réalisés avec un coût beaucoup moins élevé que les ensembles d'amplification et source d'alimentation de l'art antérieur puisqu'ils comportent peu de composants discrets et notamment aucun transformateur de sortie. De préférence, l'ensemble d'amplification et la source de tension seront réalisés sous forme de circuit intégré. Les différents circuits peuvent être réalisés soit suivant la technologie hybride, soit suivant la technologie monolithique, excepté dans le cas de l'utilisation d'un photocoupleur comme circuit d'isolement, ce dernier circuit
ne pouvant être obtenu que suivant une technologie hybride.

Par ailleurs, la bande passante de cet ensemble d'amplification et de la source de tension est
très élevée puisqu'elle est comprise entre 0 et
50 kHz, cette bande passante étant limitée uniquement
aux performances des amplificateurs opérationnels.

De plus, la puissance de cet ensemble d'amplification et de cette source de tension n'est fonction que du nombre de transistors de puissance utilisé. Par exemple, on peut obtenir, avec deux circuits
d'amplification connectés suivant la configuration en
H et associés chacun à un amplificateur de type push-
pull série, une puissance de 2 KW pour une alimentation sur le triphasé de 380 V redressé en hexaphasé,
c'est-à-dire une alimentation de 513 V avec un taux
d'ondulation de 4%, et une impédance de charge de 16 $\Omega$.

On va maintenant donner le type des amplificateurs opérationnels et des transistors ainsi que la
valeur des différents éléments pouvant être utilisés
pour constituer l'ensemble d'amplification et la source de tension, conformément à L'invention.

Comme amplificateurs opérationnels présentant notamment une bande passante comprise entre 0 et
50 kHz, on pourra utiliser, soit des amplificateurs
opérationnels connus sous la dénomination AM 303, soit
des amplificateurs opérationnels connus sous la dénomination 1 480 de chez Télédyne Phylbrick. Etant donné
que ces derniers consomment plusieurs dizaines de milliampères, il sera préférable d'utiliser l'ensemble
d'amplification comportant le montage Darlington
(deuxième variante).

16

0083529

Les transistors utilisés devant supporter des tensions élevées pourront être par exemple des transistors connus sous les dénominations MJE 340 pour les transistors NPN et MJE 350 pour les transistors PNP.

Comme valeurs de résistances, on pourra prendre R et $R_6$ de l'ordre de 10 k$\Omega$, $R_1$ et $R_2$ de l'ordre de 110 k$\Omega$ pour montage Darlington et $R_2$ de l'ordre de 130 $\Omega$ pour l'autre montage, $R_3$ et $R_4$ de l'ordre de 150 k$\Omega$, $R_5$ de l'ordre de 430 k$\Omega$, $R_7$ de l'ordre de 1 K$\Omega$, $R_8$ de l'ordre de 10 $\Omega$, et le potentiomètre 22 pourra être constitué d'une résistance de 100 $\Omega$.

Comme valeur du condensateur C, on pourra prendre 0,1 µF.

Bien entendu, le choix des amplificateurs opérationnels et des transistors, ainsi que la valeur des résistances et du condensateur ne sont donnés qu'à titre d'exemple.

B 7381 C/CL

0083529

## REVENDICATIONS

1. Ensemble d'amplification pour tension de fortes excursions, caractérisé en ce qu'il comprend un circuit d'amplification (2) comportant un amplificateur opérationnel (4, R, $R_3$) relié électriquement à un premier (8, 12) et à un deuxième circuits (10, 14) permettant de moduler la tension d'alimentation de l'amplificateur opérationnel (4, R, $R_3$) par le signal de sortie fourni par ledit amplificateur, chaque circuit de modulation étant relié d'une part, à une source d'alimentation électrique dont la tension est n fois la tension d'alimentation de l'amplificateur opérationnel, et d'autre part, à un pont diviseur par n (6), branché entre la source d'alimentation dudit circuit de modulation et la sortie (S) de l'amplificateur opérationnel.

2. Ensemble d'amplification selon la revendication 1, caractérisé en ce que les ponts diviseurs (6) sont des ponts diviseurs par deux.

3. Ensemble d'amplification selon la revendication 2, caractérisé en ce que :
- le premier circuit de modulation comprend un transistor de type NPN (8) dont l'émetteur commande une entrée d'alimentation positive de l'amplificateur opérationnel (4) et dont le collecteur est relié directement à la borne positive d'une première source d'alimentation électrique ;
- le deuxième circuit de modulation comprend un transistor de type PNP (10) dont l'émetteur est relié directement à une entrée d'alimentation négative de l'amplificateur opérationnel (4, R, $R_3$) et dont le collecteur est raccordé à la borne négative d'une deuxième source d'alimentation électrique ; et

B 7381 C/CL

- chaque pont diviseur (6) comprend deux résistances $R_1$ et $R_2$ reliées en série dont le point commun est connecté directement à la base du transistor (8, 10) auquel le pont diviseur est relié.

4. Ensemble d'amplification selon la revendication 3, caractérisé en ce que l'émetteur du transistor de type NPN (8) est connecté directement à l'entrée d'alimentation positive de l'amplificateur opérationnel (4, R, $R_3$) et en ce que le collecteur du transistor de type PNP (10) est connecté directement à la borne négative de la deuxième source d'alimentation électrique.

5. Ensemble d'amplification selon la revendication 3, caractérisé en ce que l'émetteur du transistor de type NPN (8) est connecté directement à la base d'un deuxième transistor de type NPN (12), dont l'émetteur est connecté directement à l'entrée d'alimentation positive de l'amplificateur opérationnel (4, R, $R_3$) et dont le collecteur est relié directement à la borne positive de la première source d'alimentation électrique, et en ce que le collecteur du transistor PNP est connecté directement à la base d'un troisième transistor de type NPN (14), dont le collecteur est connecté directement à l'entrée d'alimentation négative de l'amplificateur opérationnel (4) et dont l'émetteur est relié directement à la borne négative de la deuxième source d'alimentation électrique.

6. Ensemble d'amplification selon l'une quelconque des revendications 1 à 5, caractérisé en ce que le circuit d'amplification comprend, aussi, au moins un amplificateur de type push-pull série, branché en parallèle sur l'amplificateur opérationnel (4, R, $R_3$).

7. Ensemble d'amplification selon la revendication 6, caractérisé en ce que l'amplificateur

B 7381 C/CL

0083529

de type push-pull comprend un montage de type Darlington.

8. Ensemble d'amplification selon l'une quelconque des revendications 1 à 7, caractérisé en ce qu'il comprend un autre circuit d'amplification, les deux circuits d'amplification étant connectés suivant une configuration en H.

9. Ensemble d'amplification selon la revendication 8, caractérisé en ce qu'il comprend, de plus, un circuit d'isolement relié à une entrée de l'un des deux circuits d'amplification (2a, 2b), la sortie de l'un des deux circuits correspondant à la sortie de l'ensemble d'amplification et la sortie de l'autre circuit étant reliée à la masse.

10. Ensemble d'amplification selon l'une quelconque des revendications 1 à 9 , caractérisé en ce qu'il se présente sous la forme d'un circuit intégré.

11. Source de tension, caractérisée en ce qu'elle comprend un ensemble d'amplification selon la revendication 8 et en ce qu'elle comprend un générateur de fonction (15) relié à une entrée de l'un des deux circuits d'amplification (2a, 2b), la sortie de l'un des deux circuits correspondant à la sortie de la source et la sortie de l'autre circuit étant reliée à la masse.

12. Source de tension selon la revendication 11, caractérisée en ce qu'elle se présente sous la forme d'un circuit intégré.

# FIG.1

# FIG.3

# FIG.4

# FIG.2

# FIG.5

0083529

FIG.6

FIG.7